(19) Europäisches Patentamt
European Patent Office
Office européen des brevets

(11) **EP 2 403 899 B1**

(12) **FASCICULE DE BREVET EUROPEEN**

(45) Date de publication et mention
de la délivrance du brevet:
**15.01.2020 Bulletin 2020/03**

(51) Int Cl.:
**C08J 7/18** *(2006.01)*        **C23C 14/48** *(2006.01)*

(21) Numéro de dépôt: **10715300.9**

(86) Numéro de dépôt international:
**PCT/FR2010/050379**

(22) Date de dépôt: **05.03.2010**

(87) Numéro de publication internationale:
**WO 2010/100384 (10.09.2010 Gazette 2010/36)**

(54) **PROCECE DE TRAITEMENT D'UNE SURFACE D'UNE PIECE EN ELASTOMERE PAR DES IONS MULTIENERGIES HE+ ET HE2+**

VERFAHREN ZUR BEHANDLUNG EINER OBERFLÄCHE EINES ELASTOMERTEILS MIT MULTIENERGETISCHEN IONEN HE+ UND HE2+

METHOD FOR TREATING A SURFACE OF AN ELASTOMER PART MULTI-ENERGY IONS HE+ AND HE2+

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **05.03.2009 FR 0901002**

(43) Date de publication de la demande:
**11.01.2012 Bulletin 2012/02**

(73) Titulaire: **Quertech**
**14000 Caen (FR)**

(72) Inventeurs:
 • BUSARDO, Denis
 F-14510 Gonneville sur Mer (FR)
 • GUERNALEC, Frédéric
 F-35340 Liffre (FR)

(74) Mandataire: **Plasseraud IP**
**66, rue de la Chaussée d'Antin**
**75440 Paris Cedex 09 (FR)**

(56) Documents cités:
WO-A-2004/104074        WO-A-2005/094214
WO-A-2007/115309        WO-A-2008/141141
WO-A2-2008/047049        FR-A- 2 917 753
FR-A1- 2 899 242        FR-A1- 2 907 797
US-A- 4 740 282        US-A- 5 529 631

• DATABASE WPI Week 199117 Thomson Scientific, London, GB; AN 1991-120094 XP002548538 -& JP 3 057629 A (HOYA CORP) 13 mars 1991 (1991-03-13)

Remarques:
Le dossier contient des informations techniques présentées postérieurement au dépôt de la demande et ne figurant pas dans le présent fascicule.

**Description**

L'invention a pour objet un procédé de traitement d'une pièce en élastomère par des ions multi-énergies $He^+$ et $He^{2+}$.

L'invention trouve des applications par exemple dans le domaine du biomédical, ou de l'automobile où l'on cherche par exemple à diminuer le frottement d'une pièce en élastomère sur une surface de contact pour diminuer les forces de résistance, l'usure abrasive ou encore les nuisances sonores.

Le contact d'un élastomère avec une surface dure rugueuse se traduit par l'enveloppement des aspérités de la surface antagoniste. Celui-ci engendre une force tangentielle qui est résultante d'une force adhésive (due aux forces de Van Der Walls) et d'une force de déformation. La force déformation est en rapport avec le retard mis par l'élastomère pour retrouver sa forme initiale après avoir épousé les aspérités de la surface antagoniste. Ce retard est appelé composante d'hystérésis du frottement et dépend des propriétés viscoélastiques de l'élastomère. Augmenter l'élasticité revient à diminuer ce temps de retard. La force de frottement est égale à la somme d'une force de frottement et d'une force d'hystérésis.

Le coefficient de frottement dépend essentiellement :

- de la composition superficielle de l'élastomère

- de composition superficielle de la surface antagoniste

- de la rugosité de la surface antagoniste

- de la pression de contact

- de la température

L'adhésion est un phénomène important dans le cas des élastomères qui se traduit par des énergies de l'ordre de 100 $mJ/m^2$.

On définit les élastomères par leur glissance, G, qui est inversement proportionnelle à leur coefficient de frottement, $\mu$. La glissance s'exprime de la manière suivante :

$$G = (1/\mu) = (1/s).(m+p),$$

où s représente l'adhésion, m l'aptitude de l'élastomère à épouser la surface antagoniste et p la pression de contact. A titre d'exemple, en mode statique le coefficient de frottement d'un caoutchouc naturel varie entre 4 et 1,5 pour une pression variant de 0,5 à 3 bars.

En mode dynamique, une augmentation de la vitesse produit un pic d'adhésion de l'élastomère lorsque l'on approche des vitesses de fluage, et un pic d'hystérésis à très hautes vitesses.

Les élastomères ont une particularité sonore. Sous l'effet du déplacement il apparaît dans l'aire de contact des zones de décollement entre l'élastomère et la surface antagoniste. Il se produit alors un processus de reptation de la surface de l'élastomère constituée d'ondes de décollement se propageant en sens inverse de l'effort de frottement. Ceci donne lieu à un bruit de crissement constituant une réelle nuisance sonore. Pour corriger cela une voie peut consister à réduire la différence existant entre coefficient de frottement statique et dynamique. Dans ce but, il existe des méthodes chimiques classiques d'halogénation applicables seulement à une minorité d'élastomères: le procédé de fluorination, de bromination ou encore de chlorination. Ces procédés présentent de grands inconvénients : ils sont très polluants, ils nécessitent de chauffer de très grandes quantités d'eau, qu'il faut ensuite filtrer dans des stations de retraitement fort couteuses. L'efficacité de ces procédés d'halogénation dépend grandement de la composition chimique de l'élastomère, de sa richesse en double liaisons chimiques susceptibles de faire l'objet d'une addition électrophile. Par exemple, il est très difficile de les appliquer sur un élastomère de type EPDM (éthylène propylène diène monomère). On préconise dans ce cas une chlorination à très haute température.

Outre les problèmes de frottement, les pièces en élastomère doivent souvent fonctionner dans des milieux chimiques plus ou moins agressifs, à l'humidité ambiante, à l'oxygène ambiant, à des températures très basses ou au contraire très élevées, etc. ce qui peut entrainer un vieillissement accéléré.

Certains élastomères sont chargés en agents chimiques de protection contre les UV, l'oxydation. Le rejet de ces agents chimiques vers l'extérieur a pour effet de faire perdre à l'élastomère ses propriétés mécaniques superficielles.

D'autres élastomères, très bons d'un point de vue mécanique, sont pourtant exclus de tout usage médical ou pharmaceutique en raison des risques minimes de rejets toxiques. On se prive de fait d'excellents élastomères.

Certain élastomères sont isolants, et peuvent attirer les poussières, les retenir ou encore coller en raison de charges électrostatiques accumulées sur leur surface durant le processus de fabrication.

Certains élastomères nécessitent l'usage de talc pour éviter le collage de pièces les unes aux autres durant le processus de fabrication, ou d'assemblage.

L'invention a pour but de diminuer les inconvénients précités et notamment de permettre une diminution du frottement superficiel d'une pièce en élastomère massive tout en conservant dans la masse ses propriétés viscoélastiques et en évitant l'utilisation de traitements chimiques polluants. L'invention propose ainsi un procédé de traitement d'au moins une surface d'une pièce massive en élastomère par des ions d'hélium caractérisé en ce qu'on implante simultanément des ions multi-énergies $He^+$ et $He^{2+}$, où le ratio RHe, où RHe = $He^+/He^{2+}$ avec $He^+$ et $He^{2+}$ exprimés en pourcentage atomique est inférieur ou égal à 100, par exemple inférieur à 20.

En outre, la tension d'extraction de la source permettant l'implantation des ions multi-énergies $He^+$ et $He^{2+}$ est comprise entre 10 et 400 kV, la dose d'ions multi-énergie $He^+$ et $He^{2+}$ est comprise entre $5.10^{14}$ et $10^{18}$ ions/cm$^2$, et les ions d'hélium multi-énergies $He^+$ et $He^{2+}$ sont obtenus simultanément en extrayant avec une même et unique tension d'extraction des ions mono- et multi-chargés créés dans la chambre à plasma d'une source d'ions à résonance cyclotronique électronique (source RCE).

Les inventeurs ont pu constater que la présence simultanée d'ions $He^+$ et $He^{2+}$ permet d'améliorer très significativement des propriétés de surface d'élastomères par rapport aux traitements connus où seuls des ions de $He^+$ ou d'$He^{2+}$ sont implantés. Ils ont pu démontrer qu'une amélioration significative était obtenue pour RHe inférieur ou égal à 100, par exemple inférieure ou égal à 20.

On note que l'invention permet de réduire l'adhésion d'une pièce en élastomère massive sur une surface antagoniste, et/ou de réduire la composante d'hystérésis superficielle d'une pièce en élastomère massive, et/ou de réduire l'usure abrasive d'une pièce en élastomère massive, et/ou de réduire le collage entre pièces constituées du même élastomère, et/ou de supprimer le collage de la poussière.

L'invention permet par ailleurs d'augmenter la résistance chimique de l'élastomère en créant par exemple une barrière de perméation. Cette dernière peut ralentir la propagation de l'oxygène ambiant dans l'élastomère, et/ou retarder la diffusion d'agents de protection chimiques contenus dans l'élastomère vers l'extérieur, et/ou inhiber le relargage d'agents toxiques contenu dans l'élastomère vers l'extérieur.

Avantageusement, elle permet de supprimer les procédés polluants courants comme la fluorination, la bromination, la chlorination et de leur substituer un procédé physique applicable à tout type d'élastomère qui est peu coûteux en consommation de matière et d'énergie.

Dans le cadre de la présente invention, on entend par « massive » une pièce en élastomère produite par transformation mécanique ou physique d'un bloc de matière, par exemple par extrusion, moulage ou toute autre technique adaptée à transformer un bloc d'élastomère. De telles transformations permettent d'obtenir des pièces massives de forme variées, par exemple des pièces tridimensionnelles, des pièces sensiblement bidimensionnelles telles par exemple des bandes profilées ou des plaques, des pièces sensiblement unidirectionnelles, tels des fils.

Parmi les produits en élastomères qui peuvent être avantageusement traités par le procédé de la présente invention, on citera en exemples, les joints d'étanchéité de carrosseries, les joints racleurs de vérins hydrauliques, les joints d'étanchéité toriques, les joints à lèvres, les joints d'étanchéité de roulement à billes, les balais d'essuie glaces, les bords d'attaques d'ailes d'avion, les bords d'attaque de nacelle, les têtes de pistons de seringues hypodermiques.

Par ailleurs, il va de soi que la pièce massive en élastomère peut être une partie d'une pièce en autre matériau, par exemple rapportée sur cette pièce en autre matériau.

A titre d'exemples et parmi les élastomères on peut citer les matériaux suivants qu'il est intéressant de traiter selon l'invention :

- Les caoutchoucs naturels qui présentent une bonne résistance à l'usure, à la déchirure, à l'abrasion, un grand allongement à la rupture ;

- Les caoutchoucs nitriles qui permettent par exemple d'obtenir des joints résistants à l'eau chaude, à la vapeur, aux acides faibles, aux alcalis et aux solutions salines ;

- Les polychloroprènes (par exemple la référence commerciale Néoprène ® de la société du Pont de Nemours) qui présentent une excellente résistance à l'abrasion, aux huiles, essences, graisses, solvants, à l'ozone et à de nombreux produits chimiques et ont une bonne reprise élastique après maintien sous charge ;

- Les éthylène-propylènes de type EPM ou EPDM (par exemple la référence commerciale Nordel ® de la société du Pont de Nemours ou Vistalon ® de la société Esso-Chimie) qui sont particulièrement résistant à l'ozone, aux acides et alcalis, détergents, glycols, et restent flexibles à très basse température (-65°C) ;

- Les élastomères acryliques (par exemple la référence commerciale Hycar ® de la société Goodrich) qui sont utilisables de -40 à 200°C, avec une bonne résistance à la compression, et supportent bien les lubrifiants à base d'huile, de pétrole, les graisses, fluides hydrauliques, les oxydants, l'ozone, le gazole ;

- Les élastomères éthylène-acryliques (par exemple la référence commerciale Vamac ® de la société du Pont de Nemours) qui résistent très bien aux températures élevées et assez bien au froid et peuvent aussi constituer de bons amortisseurs anti-vibrations ; ils résistent en outre bien au déchirement, leurs taux d'allongement sont élevés. Par ailleurs, ils résistent aux huiles chaudes, aux lubrifiants à base d'hydrocarbure et de glycol, aux fluides de transmission ;

- Les élastomères fluorés (par exemple la référence commerciale Viton ® de la société du Pont de Nemours) présentent une exceptionnelle résistance aux huiles et agents chimiques, même aux températures élevées. Cette famille d'élastomères comprend notamment les caoutchoucs fluorocarbonés appelés FKM ;

- Les élastomères FEP (fluor-éthylène-propylène) qui ont des propriétés voisines aux élastomères fluorés et ont une très grande résistance à l'usure ;

- Les élastomères perfluorés (par exemple la référence commerciale Kalrez ® de la société du Pont de Nemours) qui ont une résistance chimique semblable à celle du PTFE et dont la température limite d'utilisation est de plus de 300 °C ;

- Les élastomères polyesters (par exemple la référence commerciale Hytrel ® de la société du Pont de Nemours) qui sont utilisés pour des applications demandant une grande résilience et une résistance exceptionnelle à la fatigue par flexion. Leur coefficient de frottement sur l'acier est assez élevé ;

- Les élastomères polyuréthanes (par exemple la référence commerciale Adiprène ® de la société du Pont de Nemours) qui sont caractérisés par une très grande résistance à l'usure et à l'abrasion, une résistance élevée à la rupture ; ils conviennent bien pour des joints d'étanchéité dans les mouvements de translation (joints racleurs), et où une grande dureté est associée à un faible coefficient de frottement ;

- Les élastomères silicones qui sont par exemple utilisés comme joints statiques, de -70 à 220°C et résistent à l'huile moteur à chaud, au gazole, à l'essence, aux liquides de refroidissement.

Grâce au procédé de la présente invention, on peut conserver la couleur d'origine de l'élastomère en lui donnant toutefois un aspect plus brillant.

On constate que les temps de traitement ne sont pas longs au regard des exigences industrielles.

En outre, le procédé est peu énergétique, peu coûteux et permet son utilisation dans un cadre industriel sans aucun impact environnemental.

Le traitement d'une pièce en élastomère est effectué par implantation simultanée d'ions d'hélium multi-énergies. Ces derniers sont obtenus en extrayant avec une même et unique tension d'extraction des ions mono- et multi-chargés créés dans la chambre à plasma d'une source d'ions à résonance cyclotronique électronique (source RCE). Chaque ion produit par ladite source présente une énergie qui est proportionnelle à son état de charge. Il en découle que les ions dont l'état de charge est le plus élevé, donc d'énergie la plus élevée, s'implantent dans la pièce en élastomère à des profondeurs plus importantes.

Une implantation avec une source RCE est rapide et peu coûteuse puisqu'elle ne nécessite pas une tension d'extraction élevée de la source d'ions. En effet, pour augmenter l'énergie d'implantation d'un ion, il est économiquement préférable d'augmenter son état de charge plutôt que d'augmenter sa tension d'extraction.

Il convient de noter que l'utilisation d'une source classique d'ions He, comme notamment les sources permettant l'implantation d'ions par immersion plasma ou les implanteurs à filament ne permet pas d'obtenir un faisceau adapté à l'implantation simultanée d'ions multi-énergies $He^+$ et $He^{2+}$, où le ratio RHe est inférieur ou égal à 100. Avec de telles sources, il est tout au plus inférieur ou égal à 1000.

Les inventeurs ont pu constater que ce procédé permet de traiter superficiellement une pièce en élastomère sans altérer les propriétés viscoélastique de masse.

Selon un mode de réalisation de la présente invention, la source est une source à résonance cyclotronique électronique produisant des ions multi-énergies qui sont implantés dans la pièce à une température inférieure à 50°C et l'implantation des ions du faisceau d'implantation est effectuée simultanément à une profondeur contrôlée par la tension d'extraction de la source.

Sans vouloir être lié par une quelconque théorie scientifique, on peut penser que dans le procédé selon l'invention, les ions excitent lors de leur passage les électrons de l'élastomère provoquant des scissions de liaisons covalentes qui se recombinent aussitôt pour engendrer, par un mécanisme dit de réticulation, une haute densité de liaisons chimiques covalentes. Cette densification en liaisons covalentes a pour effet d'augmenter superficiellement la dureté et l'élasticité, la compacité de l'élastomère et de renforcer sa résistance aux agents chimiques. Le processus de réticulation est d'autant plus efficace que l'ion est léger.

L'hélium est à ce titre un projectile avantageux puisque :

- il est très rapide au regard de la vitesse des électrons des liaisons de covalence donc très efficace pour exciter ces mêmes électrons qui n'ont pas le temps de modifier en conséquence leurs orbitales,

- il pénètre des profondeurs importantes, de l'ordre du micron,

- il interfère peu avec les atomes hydrogène de l'élastomère,

- il n'est pas dangereux,

- il ne modifie pas en tant que gaz noble les propriétés physico-chimiques de l'élastomère.

Selon différents modes de réalisation du procédé de la présente invention, qui peuvent être combinés entre eux :

- le ratio RHe, où RHe = $He^+/He^{2+}$ avec $He^+$ et $He^{2+}$ exprimés en pourcentage atomique, est supérieur ou égal à 1;

- la tension d'extraction de la source permettant l'implantation des ions multi-énergies $He^+$ et $He^{2+}$ est par exemple supérieure ou égale à 20 kV et/ou inférieure ou égale à 100 kV ;

- la dose d'ion multi-énergie $He^+$ et $He^{2+}$ est par exemple supérieure ou égale à $10^{15}$ ions /cm$^2$ et / ou inférieure ou égale à $10^{17}$ ions/cm$^2$, voire supérieure ou égale à $3.10^{15}$ ions/cm$^2$ et /ou inférieure ou égale à $10^{16}$ ions /cm$^2$;

- on détermine dans une étape préalable la variation d'une propriété caractéristique de l'évolution de la surface d'une pièce massive en élastomère, par exemple du module élastique de surface, E, de la dureté de surface, du coefficient de frottement, d'un matériau élastomère représentatif de celui de la pièce à traiter en fonction de doses d'ions multi-énergie $He^+$ et $He^{2+}$ de manière à déterminer un domaine de doses d'ions où la variation de la propriété caractéristique choisie est avantageuse et évolue de manière différenciée dans trois zones consécutives de doses d'ions formant ledit domaine de doses d'ions, avec une évolution sensiblement linéaire dans chacune de ces trois zones et où la valeur absolue de la pente de l'évolution dans la première zone et celle dans la troisième zone sont supérieures à la valeur absolue de la pente de l'évolution dans la deuxième zone et où l'on choisit la dose d'ions multi énergie $He^+$ et $He^{2+}$ dans la troisième zone de doses d'ions pour traiter la pièce massive en élastomère ;

- on règle des paramètres de la source et de déplacement de la surface de la pièce en élastomère à traiter de manière à ce que la vitesse surfacique de traitement de la surface de la pièce en élastomère à traiter soit comprise entre 0,5 cm$^2$/s et 1000 cm$^2$/s, par exemple supérieure ou égale à 1 cm$^2$/s et/ou inférieure ou égale à 100 cm$^2$/s ;

- on règle des paramètres de la source et de déplacement de la surface de la pièce en élastomère à traiter de manière à ce que la dose d'hélium implantée soit comprise entre $5.10^{14}$ et $10^{18}$ ions/cm$^2$, par exemple supérieure ou égale à $10^{15}$ ions/cm$^2$ et/ou inférieure ou égale à $5.10^{17}$ ions/cm$^2$ ;

- on règle des paramètres de la source et de déplacement de la surface de la pièce en élastomère à traiter de manière à ce que la profondeur de pénétration de l'hélium sur la surface de la pièce en élastomère traitée soit comprise entre 0,05 et 3 $\mu$m, par exemple supérieure ou égale à 0,1 $\mu$m et/ou inférieure ou égale à 2 $\mu$m ;

- on règle des paramètres de la source et de déplacement de la surface de la pièce en élastomère à traiter de manière à ce que la température de la surface de la pièce en élastomères en cours de traitement soit inférieure ou égale à 100°C, par exemple inférieure ou égale à 50°C ;

- la pièce en élastomère est par exemple une bande profilée, et ladite pièce défile dans un dispositif de traitement, par exemple à une vitesse comprise entre 5 m/min et 100 m/min ; à titre d'exemple, la pièce en élastomère est une bande profilée qui défile longitudinalement ;

- l'implantation d'hélium de la surface de la pièce à traiter est effectuée grâce à une pluralité de faisceaux d'ions multi énergies He$^+$ et He$^{2+}$ produits par une pluralité de sources d'ions ; à titre d'exemple, les sources d'ions sont disposées le long d'une direction de déplacement de la pièce à traiter ; de préférence les sources sont espacées de manière à ce que la distance entre deux faisceaux d'ions soit suffisante pour permettre à la pièce de se refroidir entre chaque implantation d'ions successive; Les dites sources produisent des faisceaux d'ions dont le diamètre est adapté à la largeur des pistes à traiter. En diminuant le diamètre des faisceaux à par exemple 5 mm on est capable de mettre un système de vide différentiel très efficace entre la source et la chambre de traitement, permettant de traiter les élastomères à 10$^{-2}$ mbar alors que le vide au niveau du système d'extraction de la source est de 10$^{-6}$ mbar ;

- l'élastomère de la pièce est choisi parmi les caoutchoucs naturels, synthétiques comme les polychloroprènes ou les composés semi-synthétiques de ces deux types d'élastomères. D'autres types d'élastomères sont envisageables compte tenu du caractère générique du processus de réticulation.

On constate que les enseignements obtenus sur un polymère (non élastomère), par exemple sur un polycarbonate, relatifs aux variations de propriété de surface obtenues par implantation d'ions He$^+$ et/ou He$^{2+}$ ne sont pas transposables aux présentes observations et avantages obtenus sur des élastomères, traités selon le procédé de l'invention.

L'invention porte également sur une pièce où l'épaisseur où l'hélium est implanté est supérieure ou égale à 50 nm, par exemple supérieure ou égale à 200 nm et dont le module élastique de surface, E, est supérieur ou égal à 15 MPa, par exemple supérieur ou égal à 20 MPa, voire supérieur ou égal à 25 MPa.

L'invention vise également l'utilisation du procédé de traitement ci-dessus pour traiter une pièce massive en élastomère choisie parmi la liste constituée d'un balai d'essuie-glace, d'un joint d'étanchéité de carrosserie, d'un joint torique, d'un joint à lèvres, d'un joint racleur de vérin hydraulique, d'un joint d'étanchéité de roulement à bille, d'un bord d'attaque d'aile d'avion, d'un bord d'attaque de nacelle de réacteur d'avion, , d'un piston de seringue hypodermique, d'une garniture automobile pour amortir les vibrations entre pièces en contact.

La présente invention est maintenant illustrée par des exemples de réalisation non limitatifs, notamment en référence aux dessins annexés dans lesquels :

- la figure 1 représente un exemple de distribution d'implantation d'hélium selon l'invention dans un caoutchouc naturel ;

- les figures 2 et 3 représentent deux exemples de profil d'implantation illustrant la variation de concentration atomique d'hélium implanté dans un caoutchouc naturel traité selon l'invention ;

- la figure 4 représente la variation du module d'élasticité de surface d'un échantillon de caoutchouc naturel traité selon l'invention, en fonction de la profondeur, pour une pluralité de doses d'hélium ;

- la figure 5 représente la variation du module d'élasticité de surface d'un échantillon de caoutchouc naturel traité selon l'invention, en fonction de la dose d'hélium, pour trois profondeurs.

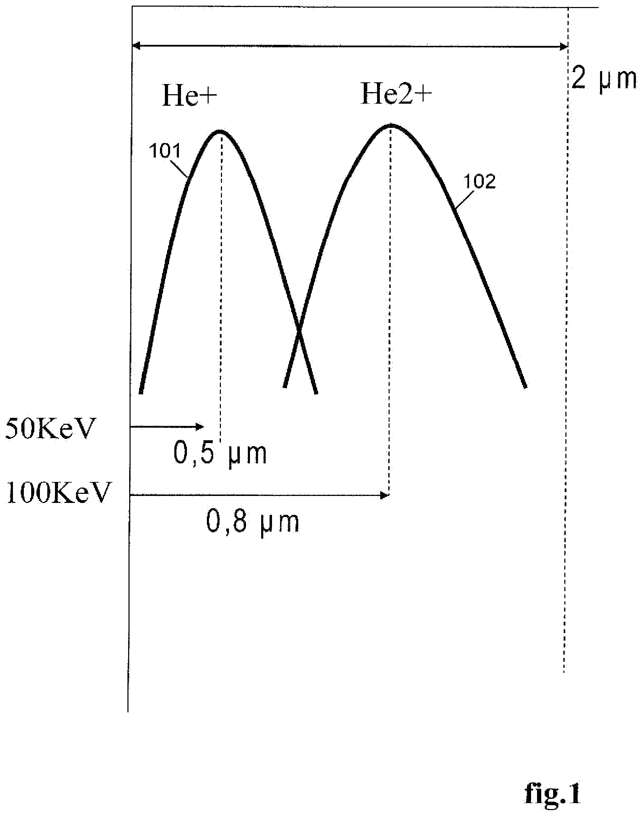

La figure 1 représente un exemple schématique de distribution d'implantation de l'hélium en fonction de la profondeur selon l'invention, dans un caoutchouc naturel. La courbe 101 correspond à la distribution d'He$^+$ et la courbe 102 à celle d'He$^{2+}$. On peut estimer que pour des énergies de 100 keV, He$^{2+}$ parcourt une distance moyenne d'environ 800 nm pour une énergie d'ionisation moyenne de 10 eV/Angstrœm. Pour des énergies de 50 keV, He$^+$ parcourt une distance moyenne d'environ 500 nm pour une énergie d'ionisation moyenne de 4 eV/Angstrœm. L'énergie d'ionisation d'un ion est en rapport avec son pouvoir de réticulation. Dans le cas où (He$^+$/He$^{2+}$) est inférieur ou égal à 100, on peut estimer que l'épaisseur maximale traitée est de l'ordre de 1000 nm soit 1 micron. Ces estimations sont cohérentes avec des observations effectuées par microscopie électronique qui ont démontré que pour un faisceau extrait à 40 kV et une dose totale de 3.10$^{15}$ ions/cm$^2$ et (He$^+$/He$^{2+}$) = 10, on observe une couche réticulée d'environ 700 à 800 nm.

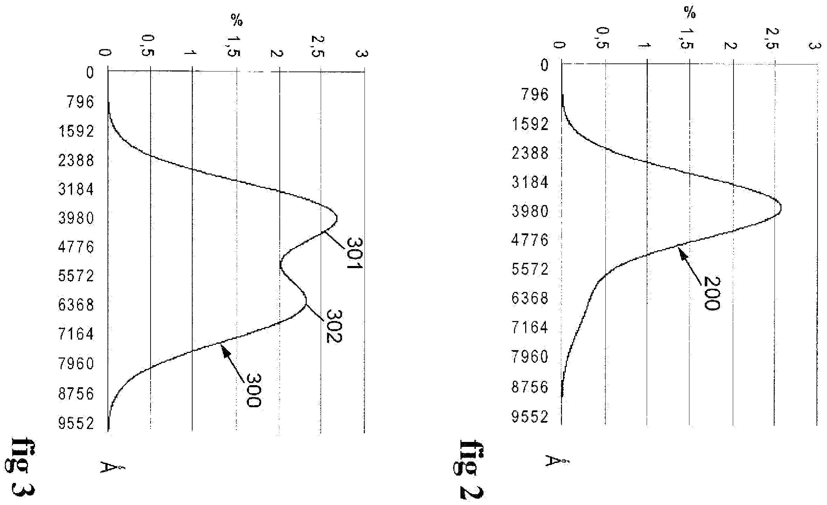

La figure 2 représente un exemple de profil d'implantation 200 illustrant la concentration atomique d'hélium implanté dans le caoutchouc naturel (exprimée en %) en fonction de la profondeur d'implantation (exprimée en Angström) ; Dans cet exemple, la dose est de 3.10$^{16}$ ions/cm$^2$ et (He$^+$/He$^{2+}$) = 10 ; He$^+$ à 50 keV ; He$^{2+}$ à 100 keV. On constate que la concentration en hélium (He$^+$ et He$^{2+}$) est largement minoritaire par rapport aux composants atomiques du caoutchouc, car cette concentration est de l'ordre de 2%. On constate que la dose maximale d'He implanté se situé à environ 0,4 $\mu$m de profondeur et qu'une quantité significative d'He est implantée jusqu'à environ 0,8 $\mu$m.

La figure 3 représente un exemple de profil d'implantation 300 illustrant la concentration atomique d'hélium implanté dans le caoutchouc naturel (exprimée en %) en fonction de la profondeur d'implantation (exprimée en Angström) ; dans cet exemple la dose est de 5.10$^{16}$ ions/cm$^2$ et (He$^+$/He$^{2+}$) = 1 ; He$^+$ à 50 keV ; He$^{2+}$ à 100 keV. On constate que deux pics 301, 302 marquent des profondeurs où l'implantation d'He est maximale et correspondent respectivement au maximum lié à l'implantation d'He$^+$, puis d'He$^{2+}$.

Plusieurs méthodes de caractérisation ont permis de faire ressortir les avantages de la présente invention.

Dans les exemples qui suivent, le traitement d'au moins une surface d'une pièce en élastomère massive par implantation d'ions d'hélium He$^+$ et He$^{2+}$ a été effectué avec des ions He$^+$ et He$^{2+}$ multi-énergies, produits simultanément par une source RCE. Les élastomères traités ont notamment été les suivants : le caoutchouc naturel (NR), le polychloroprène (CR), l'éthylène propylène diène (EPDM), le caoutchouc fluorocarboné (FKM), le nitrile (NBR), le thermoplastique (TPE). Dans tous les cas on a pu constater une diminution très significative du coefficient de frottement contre une surface en verre.

Des essais comparatifs relatifs à la mesure du coefficient de frottement ont permis de montrer que :

- le coefficient de frottement sur une surface en verre est fortement diminué. Après traitement avec 90% d'He$^+$ à 40 keV et 10% d'He$^{2+}$ à 90 keV pour une dose totale de 3.10$^{15}$ ions/cm$^2$, on mesure les coefficients de frottement reportés ci-dessous, comparés à ceux obtenus avant traitement :

| Type d'élastomère | Avant traitement | Après traitement |
|---|---|---|
| Caoutchouc naturel (NR) | 2,35 | 0,35 |
| Poly-chloroprène (CR) | 2,4 | 0,31 |
| Ethylène Propylène Diène Monomère (EPDM) | 2,1 | 0,46 |
| Caoutchouc fluoro carboné (FKM) | 4,5 | 0,6 |

- le coefficient de frottement sur une surface en verre présentant différents états de surface (sec, humide, phase séchante) est fortement diminué quel que soit l'état de surface du verre. A titre d'exemple pour un élastomère de type EPDM traité avec 90% d'He$^+$ à 40 keV et 10% d'He$^{2+}$ à 90 keV pour une dose totale de 2.10$^{15}$ ions/cm$^2$, on mesure les coefficients de frottement reportés ci-dessous :

| Etat de surface du verre | Coefficient de frottement après traitement |
|---|---|
| Sec | 0,54 |
| Humide | 0,68 |
| Phase séchante | 0,52 |

- on constate par ailleurs que la puissance de la source sonore produite par le frottement est diminuée d'au moins un facteur 2.

On peut par ailleurs constater d'autres propriétés de surface intéressantes :

- Des mesures de résistivité superficielle on été effectuées selon la norme CEI 60093 sur une plaque de caoutchouc naturel traité avec (90%) d'He$^+$ à 40 keV et 10% d'He$^{2+}$ à 90 keV pour une dose totale de 3.10$^{15}$ ions/cm. Ces tests ont révélé une diminution d'un facteur 5,2 de la résistivité superficielle après traitement. La résistivité du caoutchouc naturel traité est de 1,1 MOhm/carré, la résistivité du caoutchouc naturel brut est de 5,9 MOhm/carré. Cette diminution de résistivité superficielle se traduit par le renforcement de propriétés antistatiques de nature à éviter le collage de la poussière comme cela a pu être observé ;

- la pièce en élastomère prend après traitement selon l'invention un bel aspect brillant que l'on interprète comme une amélioration de la conductivité superficielle du matériau consécutive à la création de doubles liaisons carbonées permettant la circulation délocalisées des électrons. Les surfaces conductrices sont par nature réfléchissantes. On peut établir une relation entre la surface relative brillante (le % de surface qui réfléchit la lumière dans des conditions d'exposition identiques) et la dose reçue par l'élastomère exprimée en ions/cm2. Cette relation est sensiblement linéaire pour des doses d'ions constituées jusqu'à une dose plafond. Au delà de ce plafond, on assiste à une saturation, l'augmentation de la dose totale d'ions n'a plus d'influence sur la proportion relative de surface brillante. Cette relation peut être mise à profit pour contrôler la qualité d'un traitement effectué sur une pièce en élastomère. La méthode consiste à prendre, dans les mêmes conditions d'exposition (source lumineuse, disposition de la pièce sous la source lumineuse, angles de prise des photos), une photo numérique d'une pièce vierge et des photos numériques d'une pièce traitée avec différentes doses (exprimées en ions/cm). On transforme chaque photo numérique en noir et blanc. Chaque pixel de la photographie prend une valeur de gris comprise entre 0 et 256 bits. On fixe ensuite un seuil de niveau de gris en deca duquel le pixel est noir et dessus duquel le pixel est blanc. On calcule enfin la surface brillante de la pièce regroupant les pixels blancs et la surface sombre de la pièce regroupant les pixels noirs. La surface brillante relative exprimée en % correspond au rapport (surface pixels blancs) / (surface pixels blancs + surface pixels noirs). Cette méthode de contrôle qualité est simple, peu coûteuse et très rapide. Elle peut être facilement adaptée sur une chaine de traitement en continu. A titre d'exemple, on donne dans le tableau ci-dessous, les résultats concernant l'évolution de la surface brillante relative (exprimée en %) en fonction de la dose reçue (exprimée en ions/cm$^2$) pour une lame d'essuie glace en caoutchouc naturel traitée avec un faisceau constitué de 90% de He$^+$ à 40 keV et de 10% de He$^{2+}$ à 90 keV. La lame est exposée sous une lumière verticale avec un angle d'incidence de 45°. Les photos ont été prises dans l'axe de réflexion horizontal.

| Dose | 0 | $10^{15}$ | $2.10^{15}$ | $3.10^{15}$ | $4.10^{15}$ | $5.10^{15}$ | $6.10^{15}$ | $7.10^{15}$ |
|---|---|---|---|---|---|---|---|---|
| Surface brillante relative % | 14 | 27 | 37 | 42 | 41 | 43 | 40 | 41 |

La surface brillante relative ne représente que 14% de la surface de la lame brute (avant traitement selon l'invention). La surface brillante évolue de façon linéaire jusqu'à atteindre 41 % pour une dose de $3.10^{15}$ ions/cm$^2$. Au delà on constate un plateau de saturation, la surface brillante relative n'évolue plus et reste égale à 42% de la surface de la lame.

Selon un mode de réalisation, on estime que les propriétés de surface d'un élastomère, notamment de frottement sont significativement améliorées à partir d'une dose de $10^{15}$ ions/cm$^2$, ce qui représente une vitesse de traitement d'environ 30 cm$^2$/s pour un faisceau d'Hélium constitué de 4,5 mA d'ion He$^+$ et 0,5 mA d'ions He$^{2+}$.

L'implantation simultanée des ions d'hélium peut se faire à des profondeurs variables, en fonction des besoins et de la forme de la pièce à traiter. Ces profondeurs dépendent notamment des énergies d'implantation des ions du faisceau d'implantation ; elles peuvent par exemple varier de 0,1 à environ 3 $\mu$m pour un élastomère. Pour des applications où les contraintes mécaniques sont fortes, comme celles concernant les joints d'étanchéité de carrosserie frottant sur une vitre, on utilisera par exemple des profondeurs de traitement de l'ordre du micron. Pour des applications ou l'on recherche plutôt des propriétés par exemple d'anti collage, on pourrait se contenter par exemple d'épaisseur inférieure au micron, réduisant d'autant les temps de traitement.

Selon un mode de réalisation, on choisit les conditions d'implantation des ions He$^+$ et He$^{2+}$ de manière à ce que la pièce en élastomère conserve ses propriétés viscoélastiques de masse grâce à un maintien de la pièce à des températures de traitement inférieures à 50°C. Ce résultat peut notamment être atteint pour un faisceau d'un diamètre de 4 mm délivrant intensité totale de 60 microampères avec une tension d'extraction de 40 kV, se déplaçant à 40 mm/s sur des amplitudes de déplacement de 100 mm. Ce faisceau a une puissance par unité de surface de 20 W/cm$^2$. Pour utiliser avec la même tension d'extraction et la même puissance par unité de surface, des faisceaux d'intensité plus importante et conserver les propriétés viscoélastiques de masse, on peut suggérer une règle d'échelle qui consiste à augmenter le diamètre du faisceau, à augmenter la vitesse de déplacement et à augmenter les amplitudes de déplacements, dans un rapport correspondant à la racine carrée (intensité désirée / 60 microampères). Par exemple pour une intensité de 6 milliampères (soit 100 fois 60 microampères), le faisceau peut avoir un diamètre de 40 mm pour conserver une puissance surfacique de 20 W/cm$^2$. Il convient dans ces conditions de multiplier la vitesse par un facteur 10 et les amplitudes de déplacement par un facteur 10, ce qui donne une vitesse de 40 cm/s et des amplitudes de déplacement de 1 m. Il convient également de multiplier le nombre de passes par ce même facteur pour avoir au final la même dose de traitement exprimée en ion/cm$^2$. Dans le cas d'un défilement en continu, on peut multiplier selon le même rapport le nombre de micro accélérateurs placés par exemple sur le parcours d'une bande.

On constate en outre que d'autres propriétés de surface sont très significativement améliorées grâce à un traitement selon l'invention et que des performances qui ne semblent pas pouvoir être atteintes avec d'autres techniques ont été mises en évidence.

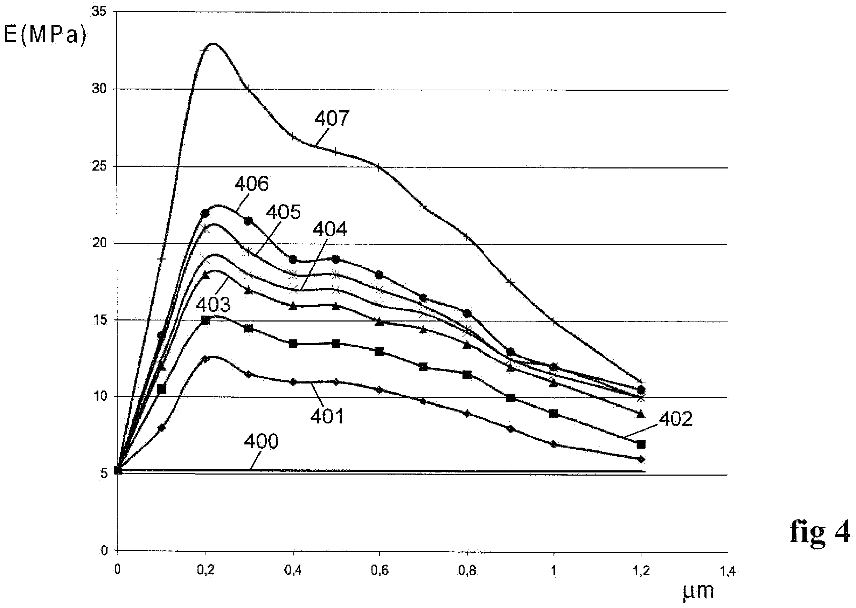

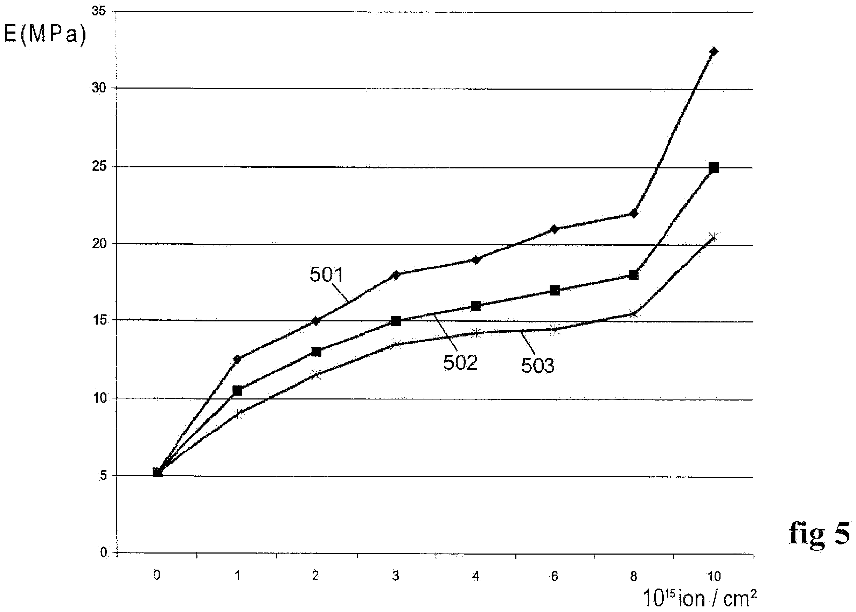

Les figures 4 et 5 représentent l'évolution du module d'élasticité de surface d'un échantillon de caoutchouc naturel traité selon l'invention, avec un faisceau d'ions He obtenu par une source RCE qui comprend 90% d'He$^+$ (de 40 keV) et 10% d'He$^{2+}$ (de 80 keV).

Les mesures de module d'élasticité de surface peuvent notamment être effectuées par des techniques de nano indentation instrumentée. Cette technique permet de caractériser mécaniquement les surfaces de matériaux avec des profondeurs de l'ordre de quelques dixièmes à quelques dizaines de nanomètres. Le principe consiste en l'application d'une charge, par l'intermédiaire d'un indenteur, sur une surface. L'appareil mesure l'enfoncement ainsi que des grandeurs (raideur, phase..) correspondant à la réponse du matériau vis-à-vis de la sollicitation. Le module élastique de surface peut ainsi être mesuré, en fonction de la profondeur. Dans le cas d'un matériau élastomère une charge est suivie d'une décharge qui présente un caractère réversible où l'analyse du comportement temporel de décharge permet de déterminer les propriétés viscoélastiques du matériau et de déduire le module d'élasticité de surface. La mesure peut être effectuée de manière statique ou dynamique.

Les publications suivantes permettent d'illustrer des méthodes de métrologie de ce type afin de déterminer le module d'élasticité de surface d'un élastomère :

Loubet J.L. Georges J.M., Marchesini O. et al. "Vickers indentation Curves of Magnésium Oxide (MgO) » - Journal of Tribology, 1984, vol. 106, pp. 43-48;

Loubet J.L., Bauer M., Tonck A., et al. « Nanoindentation with a surface force apparatus » - Mechanical properties and déformation of materials having ultra-fine microstructures. K.A. Press, 1993;

Pethica J.B., Hutchings R et Oliver W.C. - Philosophical Magazine, 1983, vol. A48(4), pp. 593-606;

Lucas B.N., Oliver W.C., Pharr G.M. et al. « Time dépendent déformation during indentation testing » - Materials Research Society Symposia Proceedings ,1997, vol. 436, pp. 233-238;

Briscoe B.J., Fiori L.et Pelillo E. « Nano-indentation of polymeric surfaces » - Journal of Physics - Part D : Applied Physics, 1998, vol. 31, pp. 2395-2405.

En figure 4, les valeurs mesurées du module d'élasticité de surface (exprimées en MPa) sont reportées en fonction de la profondeur (exprimée en $\mu$m) à partir de la surface extérieure traitée pour différentes doses d'ion He, où les courbes reportées correspondent aux doses d'ions figurant dans le tableau ci-dessous :

| Courbe | Dose d'ions He |
|---|---|
| 400 | Echantillon de référence (0 ion / cm$^2$) |
| 401 | $1.10^{15}$ ions /cm$^2$ |
| 402 | $2.10^{15}$ ions / cm$^2$ |
| 403 | $3.10^{15}$ ions / cm$^2$ |
| 404 | $4.10^{15}$ ions / cm$^2$ |
| 405 | $6.10^{15}$ ions / cm$^2$ |
| 406 | $8.10^{15}$ ions / cm$^2$ |
| 407 | $10.10^{15}$ ions / cm$^2$ |

En figure 5 les valeurs mesurées de module d'élasticité de surface sont reportées en fonction de la dose d'ions He (exprimée en $10^{15}$ ions/cm$^2$) où les courbes reportées 501, 502, 503 correspondent respectivement à une mesure effectuée pour une profondeur de 0,2 ; 0,6 ; 0,8 $\mu$m.

On constate que des pièces en élastomère dont le module de surface, E, est supérieur ou égal à 15 MPa, par exemple supérieur ou égal à 20 MPa, voire supérieur ou égal à 25 MPa peuvent être obtenues. Ces valeurs de modules élastiques de surface sont remarquables et n'ont pas été répertoriées pour des élastomères. De manière surprenante on constate que l'évolution du module élastique de surface, E, évolue de manière différenciée dans trois zones consécutives de doses d'ions d'He, avec une évolution sensiblement linéaire dans chacune de ces trois zones : de 0 à environ $3.10^{15}$ ions/cm$^2$, le module élastique de surface croit très sensiblement ; d'environ $3.10^{15}$ ions/cm$^2$ à environ $8.10^{15}$ ions/cm$^2$, le module élastique de surface croît plus lentement, et sa croissance est plus rapide au-delà d'environ $8.10^{15}$ ions/cm$^2$. Cette observation est remarquable car il est communément admis que l'implantation d'ions peut permettre une amélioration d'une propriété caractéristique de l'évolution d'une surface d'un matériau organique et que cette amélioration atteint un plafond suivi en général d'une dégradation de ladite propriété quand la dose d'ions implantée augmente.

En l'espèce, on constate qu'au-delà d'une deuxième zone, située entre environ $3.10^{15}$ ions/cm$^2$ et environ $8.10^{15}$ ions/cm$^2$, que l'on peut qualifier de zone plateau, une propriété caractéristique de l'évolution d'une surface d'un élastomère peut grandement s'améliorer.

Selon un mode de réalisation, où l'on souhaite obtenir de très significatives améliorations d'une propriété de surface d'un élastomère, on détermine un domaine de doses d'ions où la variation de la propriété caractéristique choisie est avantageuse et évolue de manière différenciée dans trois zones consécutives de doses d'ions formant ledit domaine de doses d'ions, avec une évolution sensiblement linéaire dans chacune de ces trois zones et où la valeur absolue de la pente de l'évolution dans la première zone et celle dans la troisième zone sont supérieures à la valeur absolue de la pente de l'évolution dans la deuxième zone et où l'on choisit la dose d'ions multi énergie He$^+$ et He$^{2+}$ dans la troisième zone de doses d'ions pour traiter la pièce massive en élastomère.

L'invention ne se limite pas à ces types de réalisation et doit être interprétée de façon non limitative, et englobant le traitement de tout type d'élastomère.

**EP 2 403 899 B1**

**Revendications**

1. Procédé de traitement d'au moins une surface d'une pièce massive en élastomère par des ions d'hélium **caractérisé en ce qu'**on implante simultanément des ions multi-énergies He$^+$ et He$^{2+}$, où le ratio RHe, où RHe = He$^+$/He$^{2+}$ avec He$^+$ et He$^{2+}$ exprimés en pourcentage atomique est inférieur ou égal à 100, par exemple inférieur à 20, et où la tension d'extraction de la source permettant l'implantation des ions multi-énergies He$^+$ et He$^{2+}$ est comprise entre 10 et 400 kV, où la dose d'ion multi-énergie He$^+$ et He$^{2+}$ est comprise entre 5.10$^{14}$ et 10$^{18}$ ions/cm$^2$ et où les ions d'hélium multi-énergies He$^+$ et He$^{2+}$ sont obtenus simultanément en extrayant avec une même et unique tension d'extraction des ions mono- et multi-chargés créés dans la chambre à plasma d'une source d'ions à résonance cyclotronique électronique (source RCE).

2. Procédé de traitement selon l'une quelconque des revendications précédentes **caractérisé en ce que**, le ratio RHe est supérieur ou égal à 1.

3. Procédé de traitement selon l'une quelconque des revendications précédentes **caractérisé en ce que** la tension d'extraction de la source permettant l'implantation des ions multi-énergies He$^+$ et He$^{2+}$ est supérieure ou égale à 20 kV et/ou inférieure ou égale à 100 kV.

4. Procédé de traitement selon l'une quelconque des revendications précédentes **caractérisé en ce que** la dose d'ion multi-énergie He$^+$ et He$^{2+}$ est supérieure ou égale à 10$^{15}$ ions/cm$^2$ et / ou inférieure ou égale à 10$^{17}$ ions/cm$^2$, voire supérieure ou égale à 3.10$^{15}$ ions/cm$^2$ et/ou inférieure ou égale à 10$^{16}$ ions/cm$^2$.

5. Procédé de traitement selon l'une quelconque des revendications précédentes **caractérisé en ce que** l'on détermine dans une étape préalable la variation d'une propriété caractéristique de l'évolution de la surface d'une pièce massive en élastomère, par exemple du module élastique de surface, E, de la dureté de surface, du coefficient de frottement, d'un matériau élastomère représentatif de celui de la pièce à traiter en fonction de doses d'ions multi-énergie He$^+$ et He$^{2+}$ de manière à déterminer un domaine de doses d'ions où la variation de la propriété caractéristique choisie est avantageuse et évolue de manière différenciée dans trois zones consécutives de doses d'ions formant ledit domaine de doses d'ions, avec une évolution sensiblement linéaire dans chacune de ces trois zones et où la valeur absolue de la pente de l'évolution dans la première zone et celle dans la troisième zone sont supérieures à la valeur absolue de la pente de l'évolution dans la deuxième zone et où l'on choisit la dose d'ions multi énergie He$^+$ et He$^{2+}$ dans la troisième zone de doses d'ions pour traiter la pièce massive en élastomère.

6. Procédé de traitement selon l'une quelconque des revendications précédentes **caractérisé en ce qu'**on règle des paramètres de la source et de déplacement de la surface de la pièce en élastomère à traiter de manière à ce que la vitesse surfacique de traitement de la surface de la pièce en polymère ou en élastomère à traiter est comprise entre 0,5 cm$^2$/s et 1000 cm$^2$/s, par exemple supérieure ou égale à 1 cm$^2$/s et/ou inférieure ou égale à 100 cm$^2$/s.

7. Procédé de traitement selon l'une quelconque des revendications précédentes **caractérisé en ce qu'**on règle des paramètres de la source et de déplacement de la surface de la pièce en élastomère à traiter de manière à ce que la dose d'hélium implantée soit comprise entre 5.10$^{14}$ et 10$^{18}$ ions/cm$^2$, par exemple supérieure ou égale à 10$^{15}$ ions/cm$^2$ et/ou inférieure ou égale à 5.10$^{17}$ ions/cm$^2$.

8. Procédé de traitement selon l'une quelconque des revendications précédentes **caractérisé en ce qu'**on règle des paramètres de la source et de déplacement de la surface de la pièce en élastomère à traiter de manière à ce que la profondeur de pénétration de l'hélium sur la surface de la pièce en élastomère traitée soit comprise entre 0,05 et 3 $\mu$m, par exemple supérieure ou égale à 0,1 $\mu$m et/ou inférieure ou égale à 2 $\mu$m.

9. Procédé de traitement selon l'une quelconque des revendications précédentes **caractérisé en ce que** l'on règle des paramètres de la source et de déplacement de la surface de la pièce en élastomère à traiter de manière à ce que la température de la surface de la pièce en élastomère en cours de traitement soit inférieure ou égale à 100°C, par exemple inférieure ou égale à 50°C.

10. Procédé de traitement selon l'une quelconque des revendications précédentes **caractérisé en ce que** la pièce en élastomère à traiter est une pièce automobile, par exemple une bande extrudée, et que ladite pièce défile dans un dispositif de traitement, par exemple à une vitesse comprise entre 5 m/min et 100 m/min.

11. Procédé de traitement selon l'une quelconque des revendications précédentes **caractérisé en ce que** l'implantation d'hélium de la surface en élastomère de la pièce à traiter est effectuée grâce à une pluralité de faisceaux d'ions multi énergies $He^+$ et $He^{2+}$ produits par une pluralité de sources d'ions.

12. Procédé de traitement selon l'une quelconque des revendications précédentes **caractérisé en ce que** l'élastomère de la pièce est choisi parmi les caoutchoucs naturels, les caoutchoucs nitriles, les polychloroprènes, les composés de caoutchoucs naturels et synthétiques, les élastoéthylène-propylènes, les élastomères acryliques, les élastomères éthylène-acryliques, les élastomères fluorés, les élastomères fluor-éthylène-propylènes, les élastomères perfluorés, les élastomères polyesters, les élastomères polyuréthannes, les élastomères à base de silicone.

13. Pièce en élastomère comprenant au moins une surface avec de l'hélium implanté **caractérisé en ce que** l'épaisseur où l'hélium est implanté est supérieure ou égale à 50 nm, par exemple supérieure ou égale à 200 nm et dont le module élastique de surface, E, est supérieur ou égal à 15 MPa, par exemple supérieur ou égal à 20 MPa, voire supérieur ou égal à 25 MPa.

14. Utilisation du procédé de traitement selon l'une quelconque des revendications 1 à 12 pour traiter une pièce massive en élastomère choisie parmi la liste constituée d'un balai d'essuie-glace, d'un joint d'étanchéité de carrosserie, d'un joint racleur de vérin hydraulique, d'un joint torique, d'un joint à lèvre, d'un bord d'attaque de nacelle de réacteur, d'un bord d'attaque d'aile d'avion, d'un piston de seringue hypodermique, d'une pièce de garniture automobile pour amortir les vibration, d'un joint d'étanchéité de roulement à bille.

**Patentansprüche**

1. Behandlungsverfahren mindestens einer Oberfläche eines massiven Elastomerteils mit Heliumionen, **dadurch gekennzeichnet, dass** gleichzeitig multi-energetische Ionen $He^+$ und $He^{2+}$ implantiert werden, wobei das Verhältnis RHe, mit RHe = $He^+$/$He^{2+}$ mit $He^+$ und $He^{2+}$ ausgedrückt als Atomprozent kleiner oder gleich 100 ist, beispielsweise kleiner 20, und wobei die Extraktionsspannung der Quelle, die die Implantation der multi-energetischen Ionen $He^+$ und $He^{2+}$ ermöglicht, zwischen 10 und 400 kV liegt, wobei die Dosis multi-energetischer Ionen $He^+$ und $He^{2+}$ zwischen $5.10^{14}$ und $10^{18}$ Ionen/cm$^2$ liegt und wobei die multi-energetischen Heliumionen $He^+$ und $He^{2+}$ gleichzeitig erhalten werden, indem mit einer einzigen Extraktionsspannung einfach und mehrfach geladene Ionen, die in der Plasmakammer erzeugt werden, aus einer Elektronencyklotronresonanz-Ionenquelle (RCE-Quelle) extrahiert werden.

2. Behandlungsverfahren nach einem der vorhergehenden Ansprüche, **dadurch gekennzeichnet, dass** das RHe-Verhältnis größer oder gleich 1 ist.

3. Behandlungsverfahren nach einem der vorhergehenden Ansprüche, **dadurch gekennzeichnet, dass** die Extraktionsspannung der Quelle, die die Implantation der multi-energetischen Ionen $He^+$ und $He^{2+}$ ermöglicht, größer oder gleich 20 kV und/oder kleiner oder gleich 100 kV ist.

4. Behandlungsverfahren nach einem der vorhergehenden Ansprüche, **dadurch gekennzeichnet, dass** die Dosis multi-energetischer Ionen $He^+$ und $He^{2+}$ größer oder gleich $10^{15}$ Ionen/cm$^2$ und/oder kleiner oder gleich $10^{17}$ Ionen/cm$^2$ oder sogar größer oder gleich $3.10^{15}$ Ionen/cm$^2$ oder kleiner oder gleich $10^{16}$ Ionen/cm$^2$ ist.

5. Behandlungsverfahren nach einem der vorgenannten Ansprüche, **dadurch gekennzeichnet, dass** in einem vorangehenden Schritt die Variation einer für die Entwicklung der Oberfläche eines massiven Elastomerteils charakteristischen Eigenschaft, beispielsweise des Elastizitätsmoduls der Oberfläche, E, der Oberflächenhärte, des Reibungskoeffizienten, eines elastomeren Materials, das für das Material des zu behandelnden Teils repräsentativ ist, in Abhängigkeit von den Dosen multi-energetischer Ionen $He^+$ und $He^{2+}$, zur Bestimmung eines Ionendosisbereichs, in dem die Variation der gewählten charakteristischen Eigenschaft vorteilhaft ist und sich differenziert in drei aufeinanderfolgenden Ionendosiszonen entwickelt, die den Ionendosisbereich bilden, mit einer im Wesentlichen linearen Entwicklung in jeder dieser drei Zonen und wobei der Absolutwert der Entwicklungssteigung in der ersten Zone und der Absolutwert in der dritten Zone größer sind als der Absolutwert der Entwicklungssteigung in der zweiten Zone und wobei die Dosis multi-energetischer Ionen $He^+$ und $He^{2+}$ in der dritten Ionendosiszone gewählt ist, um das massive Elastomerteil zu behandeln.

6. Behandlungsverfahren nach einem der vorhergehenden Ansprüche, **dadurch gekennzeichnet, dass** Parameter der Quelle und der Verlagerung der Oberfläche des zu behandelnden Elastomerteils so eingestellt werden, dass die Oberflächenbehandlungsrate der Oberfläche des zu behandelnden Polymer- oder Elastomerteils zwischen 0,5 cm$^2$/s und 1000 cm$^2$/s liegt, beispielsweise größer oder gleich 1 cm$^2$/s und/oder kleiner oder gleich 100 cm$^2$/s ist.

7. Behandlungsverfahren nach einem der vorhergehenden Ansprüche, **dadurch gekennzeichnet, dass** Parameter der Quelle und der Verlagerung der Oberfläche des zu behandelnden Elastomerteils so eingestellt werden, dass die implantierte Heliumdosis zwischen 5.10$^{14}$ und 10$^{18}$ Ionen/cm$^2$ liegt, beispielsweise größer oder gleich 10$^{15}$ Ionen/cm$^2$ und/oder kleiner oder gleich 5.10$^{17}$ Ionen/cm$^2$ ist.

8. Behandlungsverfahren nach einem der vorhergehenden Ansprüche, **dadurch gekennzeichnet, dass** Parameter der Quelle und der Verlagerung der Oberfläche des zu behandelnden Elastomerteils so eingestellt werden, dass die Eindringtiefe von Helium auf der Oberfläche des behandelten Elastomerteils zwischen 0,05 und 3 μm liegt, beispielsweise größer oder gleich 0,1 μm und/oder kleiner oder gleich 2 μm ist.

9. Behandlungsverfahren nach einem der vorhergehenden Ansprüche, **dadurch gekennzeichnet, dass** Parameter der Quelle und der Verlagerung der Oberfläche des zu behandelnden Elastomerteils so eingestellt werden, dass die Temperatur der Oberfläche des zu behandelnden Elastomerteils kleiner oder gleich 100 °C ist, beispielsweise kleiner oder gleich 50 °C.

10. Behandlungsverfahren nach einem der vorhergehenden Ansprüche, **dadurch gekennzeichnet, dass** das zu behandelnde Elastomerteil ein Automobilteil, beispielsweise ein extrudierter Streifen, ist und dass das Teil eine Behandlungsvorrichtung durchläuft, beispielsweise mit einer Geschwindigkeit zwischen 5 m/min und 100 m/min.

11. Behandlungsverfahren nach einem der vorhergehenden Ansprüche, **dadurch gekennzeichnet, dass** die Heliumimplantation der Elastomeroberfläche des zu behandelnden Teils mittels einer Vielzahl von multi-energetischen Ionenstrahlen He$^+$ und He$^{2+}$ durchgeführt wird, die durch eine Vielzahl von Ionenquellen erzeugt werden.

12. Behandlungsverfahren nach einem der vorhergehenden Ansprüche, **dadurch gekennzeichnet, dass** das Elastomer des Teils gewählt ist aus Naturkautschuken, Nitrilkautschuken, Polychloroprenen, Natur- und Synthesekautschukzusammensetzungen, Elastoethylenpropylenen, Acryl-Elastomeren, Ethylen-Acryl-Elastomeren, Fluorelastomeren, Fluor-Ethylen-Propylen-Elastomeren, Perfluorelastomeren, Polyester-Elastomeren, Polyurethan-Elastomeren, Elastomeren auf Silikonbasis.

13. Elastomerteil, umfassend mindestens eine Oberfläche mit implantiertem Helium, **dadurch gekennzeichnet, dass** die Dicke, bei der das Helium implantiert wird, größer oder gleich 50 nm ist, beispielsweise größer oder gleich 200 nm, und dessen Oberflächenelastizitätsmodul E größer oder gleich 15 MPa ist, beispielsweise größer oder gleich 20 MPa oder größer oder gleich 25 MPa.

14. Verwendung des Behandlungsverfahrens nach einem der Ansprüche 1 bis 12 zum Behandeln eines massiven Elastomerteils, gewählt aus der Liste, umfassend ein Wischerblatt, eine Karosseriedichtung, eine Hydraulikzylinder-Abstreifdichtung, einen O-Ring, eine Lippendichtung, eine Triebwerksgondel-Vorderkante, eine Flugzeugflügel-Vorderkante, einen Subkutan-Spritzenkolben, ein Automobildichtungsteil zur Vibrationsdämpfung, eine Kugellagerdichtung.

**Claims**

1. Method for treating at least one surface of a solid elastomer part with helium ions **characterised in that** He$^+$ and He$^{2+}$ multi-energy ions are implanted simultaneously, where the ratio RHe, where RHe = He$^+$/He$^{2+}$ with He$^+$ and He$^{2+}$ expressed as an atomic percentage is less than or equal to 100, for example less than 20, and where the extraction voltage of the source for implanting He$^+$ and He$^{2+}$ multi-energy ions is between 10 and 400 kV, where the He$^+$ and He$^{2+}$ multi-energy ion dose is between 5.10$^{14}$ and 10$^{18}$ ions/cm$^2$ and where the He$^+$ and He$^{2+}$ multi-energy ions are obtained simultaneously by extracting with a single extraction voltage single- and multi-charged ions in the plasma chamber of an electron cyclotron resonance source (ECR source).

2. Treatment method according to any one of the preceding claims **characterised in that** the ratio RHe is greater than or equal to 1.

3. Treatment method according to any one of the preceding claims **characterised in that** the extraction voltage of the source for implanting He$^+$ and He$^{2+}$ multi-energy ions is greater than or equal to 20 kV and/or less than or equal to 100 kV.

4. Treatment method according to any one of the preceding claims **characterised in that** the He$^+$ and He$^{2+}$ multi-energy ion dose is greater than or equal to $10^{15}$ ions/cm$^2$ and/or less than or equal to $10^{17}$ ions/cm$^2$, or greater than or equal to $3.10^{15}$ ions/cm$^2$ and/or less than or equal to $10^{16}$ ions/cm$^2$.

5. Treatment method according to any one of the preceding claims **characterised in that** there is determined in a preliminary step the variation of a characteristic property of the development of a surface of a solid elastomer part, for example of the surface elasticity modulus, E, of the surface hardness, of the friction coefficient, of an elastomer material representative of that of the part to be treated according to He$^+$ and He$^{2+}$ multi-energy ion doses so as to determine a range of ion doses where the variation of the characteristic property chosen is advantageous and develops in a differentiated manner in three consecutive ion dose zones forming said ion dose range, with a substantially linear development in each of these three zones and where the absolute value of the slope of the development in the first zone and that in the third zone are greater than the absolute value of the slope of the development in the second zone and where the He$^+$ and He$^{2+}$ multi-energy ion dose is chosen in the third ion dose zone to treat the solid elastomer part.

6. Treatment method according to any one of the preceding claims **characterised in that** parameters of the source and of movement of the surface of the elastomer part to be treated are set such that the treatment surface rate of the surface of the polymer or elastomer part to be treated is between 0.5 cm$^2$/s and 1000 cm$^2$/s, for example greater than or equal to 1 cm$^2$/s and/or less than or equal to 100 cm$^2$/s.

7. Treatment method according to any one of the preceding claims **characterised in that** parameters of the source and of movement of the surface of the elastomer part to be treated are set such that the implanted helium dose is between $5.10^{14}$ and $10^{18}$ ions/cm$^2$, for example greater than or equal to $10^{15}$ ions/cm$^2$ and/or less than or equal to $5.10^{17}$ ions/cm$^2$.

8. Treatment method according to any one of the preceding claims **characterised in that** parameters of the source and of movement of the surface of the elastomer part to be treated are set such that the helium penetration depth on the surface of the elastomer part treated is between 0.05 and 3 $\mu$m, for example greater than or equal to 0.1 $\mu$m and/or less than or equal to 2 $\mu$m.

9. Treatment method according to any one of the preceding claims **characterised in that** parameters of the source and of movement of the surface of the elastomer part to be treated are set such that the temperature of the surface of the elastomer part undergoing treatment is less than or equal to 100°C, for example less than or equal to 50°C.

10. Treatment method according to any one of the preceding claims **characterised in that** the elastomer part to be treated is an automotive part, for example an extruded strip, and that said part passes through a treatment device, for example at a speed between 5 m/min and 100 m/min.

11. Treatment method according to any one of the preceding claims **characterised in that** the helium implantation of the elastomer surface of the part to be treated is carried out by means of a plurality of He$^+$ and He$^{2+}$ multi-energy ion beams produced by a plurality of ion sources.

12. Treatment method according to any one of the preceding claims **characterised in that** the elastomer of the part is chosen among natural rubbers, nitrile rubbers, polychloroprenes, natural or synthetic rubber compounds, elastoethylene-propylenes, acrylic elastomers, ethylene-acrylic elastomers, fluorinated elastomers, fluorinated ethylene propylene elastomers, perfluorinated elastomers, polyester elastomers, polyurethane elastomers, silicone-based elastomers.

13. Elastomer part comprising at least one surface with implanted helium **characterised in that** the thickness where the helium is implanted is greater than or equal to 50 nm, for example greater than or equal to 200 nm and the surface elasticity modulus, E, whereof is greater than or equal to 15 MPa, for example greater than or equal to 20 MPa, or greater than or equal to 25 MPa.

14. Use of the treatment method according to any one of claims 1 to 12 for treating a solid elastomer part chosen among the list consisting of a windscreen wiper, a bodywork gasket seal, a hydraulic cylinder wiper seal, an O-ring, a lip seal, an engine nacelle leading edge, an aircraft wing leading edge, a hypodermic syringe plunger, an automotive trim part to damp vibrations, a ball bearing gasket seal.

fig.1

fig 2

fig 3

fig 4

fig 5

EP 2 403 899 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LOUBET J.L. ; GEORGES J.M. ; MARCHESINI O. et al.** Vickers indentation Curves of Magnésium Oxide (MgO). *Journal of Tribology,* 1984, vol. 106, 43-48
- Nanoindentation with a surface force apparatus. **LOUBET J.L. ; BAUER M. ; TONCK A. et al.** Mechanical properties and déformation of materials having ultra-fine microstructures. K.A. Press, 1993
- **PETHICA J.B. ; HUTCHINGS R ; OLIVER W.C.** *Philosophical Magazine,* 1983, vol. A48(4), 593-606
- **LUCAS B.N. ; OLIVER W.C. ; PHARR G.M. et al.** Time dépendent déformation during indentation testing. *Materials Research Society Symposia Proceedings,* 1997, vol. 436, 233-238
- **BRISCOE B.J. ; FIORI L. ; PELILLO E.** Nano-indentation of polymeric surfaces. *Journal of Physics - Part D : Applied Physics,* 1998, vol. 31, 2395-2405